# EUROPÄISCHE PATENTANMELDUNG

(11) **EP 3 043 219 A1**
(43) Veröffentlichungstag der Anmeldung: **13.07.2016**
(21) Anmeldenummer: 15195138.1
(22) Anmeldetag: 18.11.2015
(51) Int. Cl.: G05B 19/042, G01R 31/04

(54) **VERFAHREN ZUR ÜBERPRÜFUNG DER ZUORDNUNG EINES ANTRIEBS ZU EINER STEUEREINRICHTUNG**

(30) Priorität: 16.12.2014 DE 102014226008
(71) Anmelder: KUKA Roboter GmbH, 86165 Augsburg (DE)
(72) Erfinder: GEILER, Torsten, 86179 Augsburg (DE)
(74) Vertreter: Mader, Joachim

(57) **Zusammenfassung**

Die vorliegende Erfindung betrifft ein Verfahren zur Überprüfung der Zuordnung eines Antriebs zu einer Steuereinrichtung eines Industrieroboters. Den Achsen des Roboters ist jeweils ein Antrieb zugeordnet, welcher zumindest einen Aktor, und einen Bewegungssensor umfasst. Durch die Ausgabe eines geeigneten Prüfsignals von der Steuereinrichtung an den Antrieb, und einen Vergleich des ausgegebenen Prüfsignals mit Bewegungssignalen der Bewegungssensoren kann die Zuordnung überprüft werden.

## Beschreibung

### 1. Gebiet der Erfindung

Die vorliegende Erfindung betrifft ein Verfahren zur Überprüfung der Zuordnung eines Antriebs zu einer Steuereinrichtung einer Maschine, welcher mehrere Achsen aufweist. Das Verfahren ist insbesondere für die Inbetriebnahme von neu installierten Robotersystemen einsetzbar. Weiter betrifft die Erfindung eine Entsprechende Anordnung und ein computerlesbares Medium.

### 2. Hintergrund

Bei Inbetriebnahme eines Industrieroboters ist es notwendig die Antriebe der Achsen mit der Steuereinrichtung des Industrieroboters zu konnektieren, d.h. der Steuereinrichtung die richtigen Antriebe zuzuordnen. Die Konnektierung erfolgt typischerweise durch eine Verkabelung der Komponenten mittels Signalleitungen. Unter einem Industrieroboter versteht man im Allgemeinen eine Handhabungsmaschine, die zur selbsttätigen Handhabung von Objekten mit zweckdienlichen Werkzeugen ausgerüstet und in mehreren Achsen insbesondere hinsichtlich Orientierung, Position und Arbeitsablauf programmierbar ist. Industrieroboter umfassen typischerweise eine Steuereinrichtung und einen Roboterarm mit mehreren Achsen und gegebenenfalls Gliedern, die von Antrieben, die die Steuereinrichtung ansteuert, bewegt werden. Ein Glied bildet typischerweise eine mechanische Verbindung zwischen den Gelenken zweier Achsen.

Bei einer Steuereinrichtung, welche einen Industrieroboter mit zumindest zwei Antrieben steuert, d.h. zumindest zwei Signaleingänge und -ausgänge hat, ergibt sich in der Praxis das Problem, dass die Komponenten des Antriebs der Steuereinrichtung korrekt zugeordnet werden müssen, d.h. die Verkabelung zwischen Antrieben und Steuereinrichtung korrekt ist.

Ein Antrieb umfasst üblicherweise zumindest einen Aktor und einen Bewegungssensor, welche jeweils mit einem Signalausgang, bzw. Signaleingang der Steuereinrichtung verbunden werden müssen. Sendet die Steuereinrichtung Steuersignale an den Antrieb, so veranlasst der Aktor die Glieder des Industrieroboters zu entsprechenden Bewegungen, welche von dem Bewegungssensor erfasst werden. Der Bewegungssensor sendet sodann entsprechende Bewegungssignale an die Steuereinrichtung, wodurch der Regelkreis geschlossen wird.

Die Zuordnung des Antriebs zur Steuereinrichtung, insbesondere das Verkabeln der verschiedenen Komponenten, wird üblicherweise von Hand am Ort des Aufstellens des Industrieroboters durchgeführt. Bei der Verkabelung können dabei grundsätzlich zwei Arten von Fehlern sowohl aktorseitig als auch sensorseitig auftreten. Diese sind die Invertierung von Signalleitungen und das Vertauschen von Signalleitungen. Bei der Invertierung werden die Signalleitungen derart umgepolt, dass sich die Wirkrichtung des Aktors umdreht, bzw. die Richtungsinformation des Bewegungssignals invertiert wiedergegeben wird. Das Vertauschen der Signalleitungen führt dazu, dass Antriebe an falschen Aus- bzw. Eingängen der Steuereinrichtung angeschlossen sind. D.h. ein Vertauschen führt zu einem dem Antrieb falsch zugeordnetem Bewegungs- und/oder Steuersignal, und somit zu einem nicht geschlossenen oder falsch geschlossenem Regelkreis. In Folge dessen ist die Steuereinrichtung nicht mehr in der Lage, die vom Steuerprogramm vorgesehenen, gewünschten Bewegungen der Achsen zu veranlassen.

Vor Inbetriebnahme wird die Zuordnung überprüft und ggf. eine falsche Zuordnung aufgelöst. Dazu ist es üblich, dass ein Inbetriebnehmer mit geeigneten Befehlen den Roboter einzelne Bewegungen ausführen lässt, um die Zuordnung zu überprüfen. Die Kontrolle der Bewegungen erfolgt dabei visuell. Anschließend wird die Verkabelung angepasst oder das Steuerprogramm manuell geändert. Diese Korrekturen sind insbesondere deshalb notwendig, da falsch zugeordnete Antriebe potentiell gefährlich sind. Wird beispielsweise eine schwerkraftbelastete Achse durch einen Aktor über einen geschlossenen Regelkreis im Stillstand gehalten (d.h. der Einfluss der Schwerkraft wird ausgeregelt) und liegt eine Invertierung der aktorseitigen Signalleitungen vor, so kann die Regelung dazu führen, dass der Algorithmus zum Ausgleich der Schwerkraft den Aktor in Richtung der Schwerkraft beschleunigt.

Zudem ist die Inbetriebnahme durch einen Inbetriebnehmer zeitaufwändig und auch fehleranfällig.

Aufgabe der vorliegenden Erfindung ist es, die vorangehend beschriebenen Nachteile durch ein erfinderisches Verfahren gemäß Anspruch 1 auszuräumen bzw. zu vermindern.

### 3. Ausführliche Beschreibung

Ein Aspekt betrifft ein Verfahren zur Überprüfung der Zuordnung von Antrieben einer Maschine, welche mehrere Achsen aufweist, wobei den Achsen jeweils ein Antrieb zugeordnet ist und wobei jeder Antrieb zumindest einen Aktor und einen Bewegungssensor umfasst, der der vom Antrieb zu bewegenden Achse zugeordnet ist, zu einer Steuereinrichtung, welche dazu eingerichtet ist die Maschine mittels eines Steuerprogramms zu steuern, umfassend die folgenden Verfahrensschritte:
a) die Steuereinrichtung gibt ein Prüfsignal an zumindest einen Antrieb aus;
b) der Aktor dieses Antriebs veranlasst in Reaktion auf das Prüfsignal entsprechende Bewegungen der Achsen der Maschine;
c) der zugeordnete Bewegungssensor erfasst die Bewegung und sendet entsprechende Bewegungssignale an die Steuereinrichtung , und
d) die Steuereinrichtung vergleicht das Prüfsignal mit den Bewegungssignalen, um eine Phasenverschiebung ϕ, eine Invertierung und/oder eine Änderung der Amplitude k zu detektieren.

Das Verfahren zur Überprüfung der Zuordnung eines Antriebs zu einer Steuereinrichtung ist insbesondere dafür gedacht, Fehler in der Zuordnung zu erkennen und vorzugsweise die korrekte Zuordnung zu ermitteln.

Das Verfahren kann auf Maschinen mit mehreren durch zugeordnete Antriebe antreibbaren Achsen, bevorzugt auf einem Roboter, besonders bevorzugt auf einem Gelenkarmroboter bzw. einem Industrieroboter, und weiter bevorzugt auf einer Werkzeugmaschine bzw. einer Werkstückbearbeitungsmaschine, wie beispielsweise einer Drehmaschine, einer Fräse, einer Bohrmaschine, einer Presse und so weiter, ausgeführt werden.

Zur Durchführung des Verfahrens ist eine Maschine bzw. ein Roboter bereitgestellt, welche/welcher mehrere Achsen aufweist. Den Achsen ist jeweils ein Antrieb zugeordnet, wobei jeder Antrieb zumindest einen Aktor und einen Bewegungssensor umfasst, der der vom Antrieb zu bewegenden Achse zugeordnet ist. Der Aktor ist vorzugsweise ein Elektromotor, er kann jedoch auch ein hydraulischer oder pneumatischer Aktor sein, der rotatorische oder translatorische Bewegungen ausführt. Als Bewegungssensoren kommen typischerweise Inkrementalwertgeber und vorzugsweise Absolutwertgeber zum Einsatz, welche auf resistiven, induktiven, kapazitiven oder optischen Messverfahren beruhen. Zudem wird gemäß dem Verfahren eine Steuereinrichtung bereitgestellt, welche dazu eingerichtet ist, den Industrieroboter mittels eines Steuerprogramms über Steuersignale zu steuern.

Die Steuereinrichtung gibt ein Prüfsignal an einen Antrieb aus (Schritt a)). Das Prüfsignal ist vorzugsweise ein periodisches Signal und wiederholt sich mit einer Periodendauer T. Beispiele sind Sinusschwingungen, Rechtecksignale oder Sägezahnsignale, es kommen jedoch auch andere beliebige periodische Signale in Frage. Ein Prüfsignal ist ein Steuersignal, welches die Aktoren des Roboters dazu veranlasst bestimmte, für eine Überprüfung der Zuordnung geeignete Bewegungen auszuführen.

Der Aktor veranlasst in Reaktion auf das Prüfsignal entsprechende Bewegungen der Glieder des Industrieroboters (Schritt b)). Der dem Aktor, bzw. dem Glied oder der Achse zugeordnete Bewegungssensor erfasst die Bewegung und sendet entsprechende Bewegungssignale an die Steuereinrichtung zurück (Schritt c)). Sowohl der Begriff Bewegungssignal als auch der Begriff Steuersignal wird hierin im Singular als auch im Plural verwendet, ohne dass damit eine Beschränkung auf ein oder mehrere Signale gemeint ist.

Die Steuereinrichtung vergleicht das Prüfsignal mit den Bewegungssignalen, um so eine Phasenverschiebung, eine Invertierung und/oder eine Änderung der Amplitude zu detektieren (Schritt d)). Dabei hat das Prüfsignal vorzugsweise einen Verlauf, der die Detektion einer Invertierung unabhängig von der Phasenverschiebung ermöglicht. Vorzugsweise werden die Schritte a) bis d) für alle Antriebe wiederholt.

Eine Phasenverschiebung ergibt sich beispielsweise durch Trägheiten, wie Massenträgheiten im Antrieb. Dadurch wird das Prüfsignal zeitlich verzögert in Bewegungen umgesetzt, was zu einer Phasenverschiebung im gemessenen Bewegungssignal führt. Eine Änderung der Amplitude kann beispielsweise durch die Übersetzung eines im Antrieb verwendeten Getriebes erzeugt werden. Das Übersetzungsverhältnis beeinflusst dabei den Faktor, um welchen sich die Amplitude ändert. Ist das Übersetzungsverhältnis "i" dabei das Verhältnis von Antriebsdrehzahl zu Abtriebsdrehzahl, so vergrößert sich die Amplitude für i > 1 und verkleinert sich die Amplitude für i < 1.

Eine Invertierung kann wie eingangs erwähnt aktorseitig als auch sensorseitig auftreten. Eine aktorseitige Invertierung liegt bei einer Umpolung/Invertierung der prüfsignalführenden Signalleitungen vor. In der Folge dreht/verfährt der Aktor in die entgegengesetzte Richtung der Kommandierung. Soll der Aktor beispielsweise im Uhrzeigersinn drehen, und liegt eine aktorseitige Invertierung vor, so führt der Aktor eine Drehbewegung gegen den Uhrzeigersinn durch.

Eine sensorseitige Invertierung liegt bei einer Umpolung/Invertierung der bewegungssignalführenden Signalleitungen vor. In der Folge sendet der Bewegungssensor ein Bewegungssignal, welches eine Bewegungsrichtung entgegengesetzt der tatsächlichen Bewegungsrichtung anzeigt. Dreht sich der Aktor beispielsweise im Uhrzeigersinn, und liegt eine sensorseitige Invertierung vor, so sendet der Bewegungssensor ein Bewegungssignal an die Steuereinrichtung, welches eine Bewegungsrichtung gegen den Uhrzeigersinn anzeigt. In der Praxis kann bei der Inbetriebnahme die sensorseitige Invertierung mittels einer speziellen und aufwendigen Sensorverkabelung in vielen Fällen verhindert werden. Jedoch kann auch die sensorseitige Invertierung ein Problem darstellen, insbesondere wenn etwa keine geeignet kodierte Sensorverkabelung vorliegt. Vorteilhafterweise kann jedoch mittels des Verfahrens in jedem Fall die Überprüfung der korrekten aktorseitigen Verkabelung stattfinden, so dass in jedem Fall eine Vereinfachung der Inbetriebnahme bzw. Überprüfung möglich ist.

Um eine Phasenverschiebung des Signals sicher von einer Invertierung des Signals unterscheiden zu können, sollte sichergestellt sein, dass sich bei einem periodischen Prüfsignal ein beispielsweise um die Hälfte der Periodendauer des Signals (T/2) verschobenes Signal von einem invertierten Signal unterscheidet. Beispielsweise ist bei einem sinusförmigen Signal eine Phasenverschiebung um T/2 mit einer Invertierung gleichsetzbar, d.h. nicht unterscheidbar. Bei anderen Signalformen, wie beispielsweise einem Sägezahnsignal, entspricht das invertierte Signal jedoch nicht dem um T/2 verschobenen Signal. Der Grund liegt in den unterschiedlich ausgeprägten steigenden und fallenden Flanken des Signals. Weisen diese unterschiedliche Steigungen auf, so ist eine Unterscheidung der Invertierung von einer Phasenverschiebung möglich. Die Flanken müssen dabei keine Funktion 1**.** Grades bilden, sondern sich nur in ihrer Steigung unterscheiden.

Vorzugsweise gibt das Prüfsignal für beide Bewegungsrichtungen des Aktors unterschiedliche Beschleunigungen, Geschwindigkeiten und/oder zu verfahrende Wege vor. Dies kann beispielsweise durch ein Sägezahnsignal oder ein sägezahnartiges Signal erreicht werden. Unter den Begriff "sägezahnartige Signale" werden dabei alle Signalformen verstanden, welche unterschiedliche steigende und fallende Flanken aufweisen. Der Bereich des Signals, welcher der Richtungsumkehr des Aktors entspricht kann dabei aus regelungstechnischen Gründen abgeflacht oder als stetig differenzierbare Funktion ausgeführt sein.

Bei periodischen Signalen wird die Periodendauer des Prüfsignals vorzugsweise geeignet gewählt, um eine Phasenverschiebung von einer Invertierung sicher zu unterscheiden. Ist die maximal auftretende Phasenverschiebung des Systems (= Antrieb) beispielsweise bekannt, so kann durch die Wahl eines Prüfsignals mit einer Periodendauer, die länger als doppelt so lang ist wie die maximale Phasenverschiebung auch eine sichere Unterscheidung - unabhängig von der Ausprägung der Flanken des Prüfsignals - erfolgen.

Typischerweise erfolgt die Konnektierung durch Verkabeln der Komponenten mit Signalleitungen. Alternativ kann die Konnektierung auch kabelungebunden, beispielsweise über geeignete Funkverbindungen erfolgen. Wenn hierin der Einfachheit halber von "Verkabelung" der Anschlüsse die Rede ist, so sind damit auch immer kabellose Verbindungen mit umfasst, sofern nicht explizit etwas anderes ausgedrückt wird.

Weiter weist die Steuereinrichtung vorzugsweise eine entsprechende Anzahl an Signaleingängen auf, die den jeweiligen Bewegungssensoren zugeordnet werden müssen. Vorzugsweise bilden jeweils ein Signaleingang und ein Signalausgang der Steuereinrichtung ein I/O- Paar. Ein solches I/O-Paar dient zum Schließen eines Regelkreises. Die Zuordnung eines Antriebs zu einer Steuereinrichtung umfasst demnach die Zuordnung der Signalausgänge der Steuereinrichtung zu den Aktoren der jeweiligen Antriebe, als auch die Zuordnung der Signaleingänge der Steuereinrichtung zu den Bewegungssensoren der jeweiligen Antriebe. Für eine korrekte Zuordnung wird einem I/O-Paar sowohl der entsprechende Aktor des Antriebs als auch der dem Antrieb zugehörige Bewegungssensor ohne Invertierung zugeordnet.

Vorzugsweise gibt die Steuereinrichtung, um die korrekte Zuordnung zu überprüfen, das Prüfsignal zunächst auf einem ersten Signalausgang der Steuereinrichtung aus. Folglich werden die Glieder des dem Signalausgang zugeordneten Antriebs bewegt. Durch die Überwachung aller Signaleingänge der Steuereinrichtung kann das Bewegungssignal, welches von dem bewegten Glied herrührt, auch dann erkannt werden, wenn der Sensor des betreffenden Antriebs nicht dem richtigen I/O-Paar zugeordnet ist. Ist beispielsweise der Aktor des Antriebs einem Signalausgang eines ersten I/O-Paares zugeordnet und der Bewegungssensor des Antriebs (fälschlicherweise) einem Signaleingang eines zweiten I/O-Paares, so wird das am ersten Signalausgang ausgegebene Bewegungssignal am zweiten Signaleingang detektiert. Nach Empfang des Bewegungssignals an einem der Signaleingänge wird die ermittelte Zuordnung angezeigt oder abgespeichert. Somit kann durch das Ausgeben des Prüfsignals an nur einen Antrieb und das gleichzeitige Überwachen aller Signaleingänge die tatsächlich vorliegende Zuordnung des Antriebs zur Steuereinrichtung überprüft werden. Durch das Wiederholen der Schritte a) bis d) des Verfahrens kann so die Zuordnung aller Antriebe überprüft werden.

Vorzugsweise vergleicht die Steuereinrichtung das Prüfsignal mit den empfangenen Bewegungssignalen, um die Phasenverschiebung ϕ und/oder die Änderung der Amplitude k zu detektieren. Vorzugsweise ist dabei die Phasenverschiebung ϕ und/oder die Änderung der Amplitude k für jeden Antrieb charakteristisch und bekannt, d.h. der Steuereinrichtung stehen Soll-Werte für jeden Antrieb zur Verfügung. Die Phasenverschiebung kann wie bereits erläutert beispielsweise ein Maß für die Trägheit sein und die Änderung der Amplitude ein Maß für das Übersetzungsverhältnis eines Antriebs. Die Steuereinrichtung kann folglich aufgrund dieser Soll-Werte die einzelnen Antriebe unterscheiden.

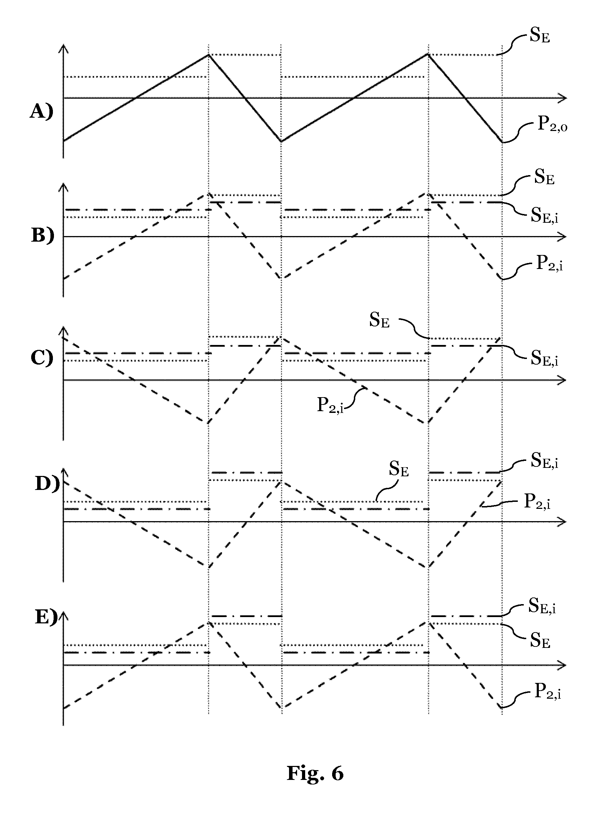

Ebenso kann durch den Vergleich von Prüfsignal und empfangenen Bewegungssignal durch die Steuereinrichtung eine Invertierung des Signals festgestellt werden. Liegt eine solche Invertierung vor, so sind die Signalleitungen des Aktors oder des Bewegungssensors invertiert. Ein exemplarisches Vorgehen zu Invertierungserkennung ist unter Fig. 6 erläutert.

Ein Aspekt betrifft eine Anordnung einer Maschine, insbesondere eines Roboters, mit zumindest zwei antreibbaren Achsen und einer Steuereinrichtung, wobei die Steuereinrichtung ausgelegt ist, das erfindungsgemäße Verfahren auszuführen.

Ein weiterer Aspekt betrifft ein computerlesbares Medium, auf welchem Instruktionen gespeichert sind, die, wenn sie auf einer geeigneten Steuereinrichtung geladen sind und ausgeführt werden, das erfindungsgemäße Verfahren durchführen.

Die Steuereinrichtung kann sowohl Hardware als auch Software umfassen, die zum Steuern des Industrieroboters notwendig ist. Die Steuereinrichtung kann räumlich und/oder logisch geteilt sein, um Steueraufgaben an mehreren Orten zu verrichten. Weiter kann die Steuereinrichtung direkt mit einem Steuerprogramm gespeist werden. Das Steuerprogramm, welches die relevanten erfindungsgemäßen Verfahrensschritte beinhaltet, kann beispielsweise über ein computerlesbares Medium der Steuereinrichtung zur Verfügung gestellt werden, oder auf einem computerlesbaren Medium in der Steuereinrichtung selbst gespeichert sein, auf das die Steuereinrichtung zugreifen kann. Weiter kann die Steuereinrichtung eine Programmiereinrichtung umfassen, welche zumindest zeitlich begrenzt an die Steuereinrichtung angeschlossen ist, um beispielsweise das Steuerprogramm der Steuereinrichtung zu ändern, oder ein modifiziertes Steuerprogramm einzuspielen.

### 4. Beschreibung bevorzugter Ausführungsformen

Im Folgenden werden bevorzugte Ausführungsformen unter Bezugnahme auf die beigefügten Figuren genauer erläutert. Hierbei zeigt:
- Fig. 1: einen Industrieroboter als bevorzugte Ausführungsform einer Maschine mit einer Steuereinrichtung;
- Fig. 2: eine schematische Darstellung eines geschlossenen Regelkreis eines Antriebs;
- Fig. 3: ein Zuordnungsbeispiel mehrere Antriebe zu einer Steuereinrichtung;
- Fig. 4: ein periodisches Prüfsignal und ein Bewegungssignal, welches eine Phasenverschiebung und eine Änderung der Amplitude aufweist;
- Fig. 5: ein periodisches, sägezahnartiges Prüfsignal und ein Bewegungssignal, welches eine Invertierung aufweist;
- Figs. 6A -E: das periodische, sägezahnartige Prüfsignal von Fig. 5 sowie entsprechende Bewegungssignale und für den Energieverbrauch des Aktors indikative Signale; und
- Fig. 7: ein periodisches Prüfsignal und ein Bewegungssignal, welches eine Phasenverschiebung, eine Änderung der Amplitude als auch eine Änderung der Flankensteigung aufweist.

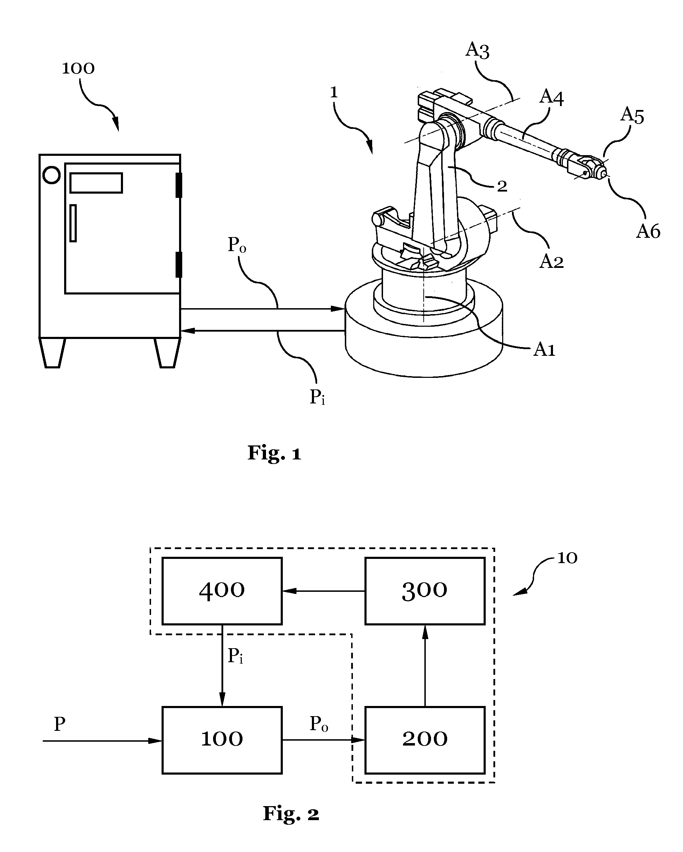

Fig. 1 zeigt einen Industrieroboter 1 mit einer zugehörigen Steuereinrichtung 100. Über die Steuersignale Pₒ können die den Achsen A1 - A6 zugeordneten Antriebe des Industrieroboters angesteuert werden. Der Aktor des jeweiligen Antriebs veranlasst in Reaktion auf das ansteuernde Steuersignal entsprechende Bewegungen der Glieder 2 des Industrieroboters 1**.** Diese Bewegungen werden von den Bewegungssensoren erfasst und ein Bewegungssignal Pi wird an die Steuereinrichtung zurückgegeben.

Fig. 2 zeigt einen schematischen geschlossenen Regelkreis eines Antriebs. Das Steuerprogramm P gibt dabei die Ist-Werte der vom Industrieroboter 1 auszuführenden Bewegung vor und veranlasst die Steuereinrichtung 100 zum Senden von Steuersignalen Pₒ an den Antrieb 10. Der Antrieb umfasst vorzugsweise zumindest eine Ansteuereinrichtung 200, zumindest einen Aktor 300 und zumindest einen Bewegungssensor 400. Die Ansteuereinrichtung kann auch in die Steuereinrichtung integriert sein. Das Risiko einer falschen Zuordnung der Aktoren bleibt durch die Integration der Ansteuereinrichtung jedoch weiter bestehen, wodurch das Verfahren analog anwendbar ist.

Die Ansteuereinrichtung 200 steuert, basierend auf den Steuersignalen Pₒ, den Aktor 300 an. Kommen elektrische Motoren zum Einsatz, wird von der Ansteuereinrichtung 200 beispielsweise der Motorstrom gestellt. Bei hydraulischen oder pneumatischen Aktoren entsprechend der Volumenfluss oder der Druck. Die vom Aktor 300 veranlassten Bewegungen der Glieder des Industrieroboters 1 werden von den Bewegungssensoren 400 erfasst und entsprechende Bewegungssignale Pi an die Steuereinrichtung 100 gesendet und somit der Regelkreis geschlossen. Bevorzugt wird die Amplitude des Prüfsignals derart gewählt, dass die Bewegungsamplitude des bewegten Glieds im Falle einer translatorischen Bewegung kleiner 1 cm, bevorzugt kleiner 0.5 cm und besonders bevorzugt kleiner 1 mm ist bzw. im Falle einer Drehbewegung des Gliedes, kleiner 1 Grad, bevorzugt kleiner 0.5 Grad und besonders bevorzugt kleiner 0.1 Grad ist.

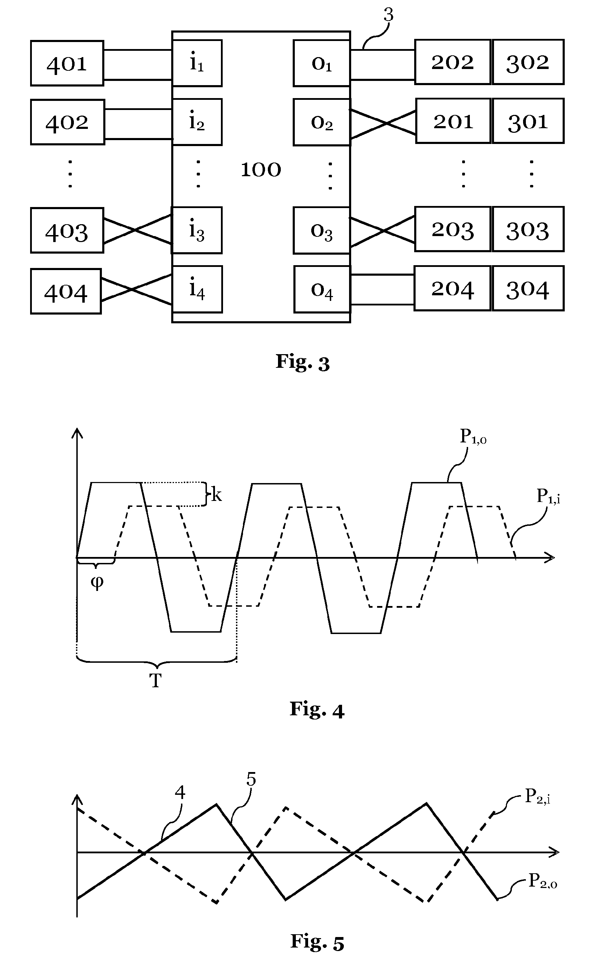

Fig. 3 zeigt ein Zuordnungsbeispiel mehrere Antriebe (hier: vier Antriebe) zu einer Steuereinrichtung 100. Dabei umfasst die Steuereinrichtung 100 beispielsweise zumindest vier Signalausgänge o₁ - o₄ und vier Signaleingänge i₁ - i₄. Über die Signalausgänge o₁ - o₄ werden die Steuersignale bzw. Prüfsignale an die vier Ansteuereinrichtungen 201-204 der vier Antriebe gesendet und die vier Aktoren 301 - 304 entsprechend angesteuert. Die Bewegungssensoren 401 - 404 erfassen die Bewegung und senden die Bewegungssignale über die Signaleingänge i₁ - i₄ zu der Steuereinrichtung 100. Die einzelnen Antriebe setzen sich in der dargestellten Ausführungsform aus je einer Ansteuereinrichtung 20x, einem Aktor 30x und einem Sensor 40x zusammen. Die Variable "x" kann entsprechend die Werte 1 - 4 annehmen und definiert somit die einzelnen Antriebe x=1-4. Eine korrekte Zuordnung der Antriebe zur Steuereinrichtung 100 ist gegeben, wenn der Antrieb x = 1 dem I/O-Paar (i₁, o₁) zugeordnet ist, und die Antriebe x= 2 - 4 entsprechend zugeordnet sind. Weiter dürfen sich für eine korrekte Zuordnung die Signalleitungen 3 nicht kreuzen. Diese Darstellungsart entspricht einer Invertierung. Das Zuordnungsbeispiel aus Fig. 3 zeigt Invertierungen der Signalleitungen 3, welche zwischen den Signalausgängen o₁ - o₄ und den Antrieben (aktorseitig), als auch zwischen den Bewegungssensoren und den Signaleingängen i₁ - i₄ (sensorseitig) auftreten. Eine doppelt auftretende Invertierung an nur einem Antrieb (vgl. x=3) ist ebenfalls möglich. Zudem können die Anriebe (x = 1 -4) den falschen I/O Paarungen zugeordnet sein (Vertauschung), wie bei den Antrieben x = 1, 2 gezeigt.

Fig. 4 zeigt ein periodisches Prüfsignal P_{1,o} und ein Bewegungssignal P_{1,i}. Prüfsignal P_{1,0} ist als durchgezogene Linie, das Bewegungssignal P_{1,i} als gestrichelte Linie dargestellt. Wie sich zeigt, stellt der Antrieb, welcher zumindest einen Aktor und einen Bewegungssensor umfasst, ein systemtheoretisch hinreichend lineares Übertragungsglied dar. Das Bewegungssignal P_{1,i}, welches vom Prüfsignal P_{1,0} abhängt, erscheint am Signaleingang der Steuereinrichtung mit veränderter Amplitude k und einer Phasenverschiebung ϕ. Sowohl das Prüfsignal als auch das Bewegungssignal weist die Periodendauer T auf. Das gezeigte periodische Prüfsignal P_{1,o} weist gleichartige steigende und fallende Flanken auf. Um zwischen einer Phasenverschiebung und einer Invertierung des Bewegungssignals unterscheiden zu können, ist in diesem Fall die Periodendauer T länger als doppelt so lang wie die maximal auftretende Phasenverschiebung gewählt (T > 2ϕ).

Fig. 5 zeigt ein besonders bevorzugtes sägezahnartiges, periodisches Prüfsignal P_{2,o} und ein zugehöriges (d.h. resultierendes) Bewegungssignal P_{2,i}, wobei das Bewegungssignal P_{2,i} hier eine Invertierung aufweist. Das Prüfsignal P_{2,0} ist als durchgezogene Linie, das Bewegungssignal P_{2,i} als gestrichelte Linie dargestellt. Die Verwendung eines sägezahnartigen periodischen Prüfsignals, wie beispielsweise einem Sägezahnsignal, ermöglicht die Detektion einer Signalinvertierung unabhängig von der Phasenverschiebung, wodurch sägezahnartige periodische Prüfsignale besonders vorteilhaft sind. Die sägezahnartigen periodischen Prüfsignale zeichnen sich dadurch aus, dass die steigenden und fallenden Flanken unterschiedlich ausgeprägt sind. Insbesondere weisen diese unterschiedliche Steigungen auf.

Die Prüfsignale der Figuren 4 und 5 sind insbesondere für den in der Praxis regelmäßig auftretenden Fall hilfreich, bei dem eine falsche Zuordnung der Bewegungssensoren aus anderen Gründen ausgeschlossen ist und nur die korrekte Zuordnung der Aktoren überprüft werden soll. Der Fachmann erkennt, dass in derartigen Fällen das Signal nicht unbedingt periodisch sein muss, sondern dass auch ein einzelnes Prüfsignal mit einer steigenden und einer fallenden Flanke ausreichend sein kann.

Figs. 6A - E zeigen das periodische, sägezahnartige Prüfsignal aus Fig. 5 sowie entsprechende Bewegungssignale und zudem für den Energieverbrauch des Aktors indikative Signale S_{E,i}. Die energieindikativen Signale S_{E,i} können beispielsweise für den Motorstrom eines Aktors repräsentativ sein. Vorzugsweise werden der Steuereinrichtung 100 diese für den Energieverbrauch des Aktors 300 indikativen Signale S_{E,i} zusätzlich bereitgestellt. Die Steuereinrichtung 100 vergleicht diese Signale S_{E,i} mit den Bewegungssignalen P_{2,i} und dem Prüfsignal P_{2,o}, um bei schwerkraftbelasteten Achsen die Bewegungsrichtungen des Aktors 100 unabhängig von den Bewegungssignalen P_{2,i} zu erfassen. So kann eine Invertierungen der Signalleitungen sowohl sensorseitig als auch aktorseitig detektiert werden.

Wird eine Invertierung der Signalleitung erkannt, so ist es in manchen Fällen wichtig zu ermitteln, ob die Invertierung sensorseitig oder aktorseitig auftritt. Während aktorseitige Invertierungen zu einer falschen Bewegungsrichtung führen, führen sensorseitige Invertierungen zu falschen Bewegungsrichtungsinformationen. Für eine korrekte Zuordnung des Antriebs müssen beide Fälle der Invertierung unterscheidbar sein. Weiterhin ist es vorteilhaft auch doppelte Invertierungen, also eine gleichzeitig auftretende aktorseitige und sensorseitige Invertierung an nur einem Antrieb erkennen zu können, nämlich in den Fällen, in denen eine sensorseitige Invertierung nicht auf anderem Wege ausgeschlossen werden kann. Im Falle einer doppelten Invertierung wird der Steuereinrichtung 100 ein vermeintlich korrektes Bewegungssignal rückgeführt. Ein solcher Fall ist in Fig. 3 an Antrieb x=3 dargestellt. Die Unterscheidung der einzelnen Invertierungsfälle ist in den Figs. 6B-6E dargestellt und im Folgenden erläutert:

Fig. 6A zeigt ein sägezahnartiges Prüfsignal P_{2,o}, wobei dieses Prüfsignal den in den Figs. 6B-6E dargestellten Bewegungssignalen P_{2,i} zugrunde liegt. Das Prüfsignal P_{2,0} kann beispielsweise die Motordrehzahl vorgeben. Das gezeigte Signal S_{E} ist ein für den Energieverbrauch des Aktors indikatives Signal, welches in der gezeigten Form auftreten würde, wenn der Antrieb eine nicht-schwerkraftbelastete Achse antreiben würde. Es ist also ein fiktives Signal. Dieses fiktive Signal S_{E} ist als Referenzwert in den Figs. 6B-6E als gepunktete Linie dargestellt. Die bei steigender Flanke des Prüfsignals benötigte Energie des Aktors ist geringer als bei fallender Flanke, da die steigende Flanke flacher ist. Dies steht beispielsweise für eine geringere Geschwindigkeit der Bewegung (bzw. Drehzahl des Motors). Zur Erläuterung der Figs. 6B-E wird angenommen, dass der Aktor mit der steigenden Flanke 4 (siehe Fig. 5) des Prüfsignals P_{2,0} die Achse entgegen der Schwerkraft bewegt. Folgendermaßen bewegt sich die Achse mit fallender Flanke 5 mit der Schwerkraft.

Figs. 6B-6E zeigen die Bewegungssignale P_{2,i} und die energieindikativen Signale S_{E,i} des Antriebs mit einer schwerkraftbelasteten Achse. Dabei zeigt Fig. 6B eine Zuordnung des Antriebs ohne Invertierung, Fig. 6C eine Zuordnung des Antriebs mit sensorseitiger Invertierung, Fig. 6D eine Zuordnung des Antriebs mit aktorseitiger Invertierung und Fig. 6E eine Zuordnung des Antriebs mit doppelter Invertierung. Wie sich zeigt, sind alle Fälle aufgrund der Signale P_{2,i} und S_{E,i} unterscheidbar. Zur Vereinfachung wurde auf die Darstellung einer Phasenverschiebung und eine Änderung der Amplitude verzichtet. Diese können jedoch ungehindert dem beschriebenen Verfahren auftreten.

Wie in Fig. 6B gezeigt führt eine korrekte Zuordnung zu einem dem Prüfsignal P_{2,o} entsprechendem Bewegungssignal P_{2,i}. Das energieindikative Signal S_{E,i} weicht jedoch vom fiktiven Signal S_{E} ab. Dies liegt daran, dass der Aktor, wenn die Achse entgegen der Schwerkraft bewegt wird, mehr Energie aufnimmt, als ohne Schwerkraftbelastung der Achse. Während der Aktor die Achse entgegen der Schwerkraft bewegt, was der steigenden Flanke des Prüfsignals P_{2,0} entspricht, wird dem Aktor also mehr Energie bereitgestellt. Das Niveau des Signals S_{E,i} liegt folglich über dem des fiktiven Signals S_{E}. Entsprechend liegt das Niveau des Signals S_{E,i} bei fallender Flanke des Prüfsignals P_{2,0} unter dem des fiktiven Signals S_{E}, was einer Bewegung der Achse mit der Schwerkraft entspricht. Die Schwerkraft unterstützt folglich die Bewegung des Aktors, wodurch weniger Energie verbraucht wird.

Die in Fig. 6C gezeigte sensorseitige Invertierung führt zu einem identischen energieindikativen Signal S_{E,i} wie in Fig. 6B, da der Antrieb real die gleiche Bewegung aufgrund des Prüfsignals P_{2,o} ausführt. Der Energiebedarf ist folglich gleich. Jedoch zeigt sich aufgrund der Invertierung der Signalleitung des Bewegungssignals P_{2,i} ein invertiertes Bewegungssignal P_{2,i}.

Die in Fig. 6D gezeigte aktorseitige Invertierung führt zu einem invertierten Bewegungssignal P_{2,i}, jedoch ist die Invertierung aufgrund des anders gearteten energieindikativen Signals S_{E,i} von der sensorseitigen Invertierung zu unterscheiden. Dies zeigt sich im Vergleich von energieindikativen Signals S_{E,i} und fiktiven Signal S_{E}. Der tatsächliche Energieverbrauch des Aktors ist bei der kommandierten Bewegungsrichtung gegen die Schwerkraft (steigende Flanke) geringer als durch das fiktive Signal angenommen. D.h. obwohl das Prüfungssignal P_{2,o} eine Bewegung gegen die Schwerkraft vorgibt, wird vom Aktor weniger Energie benötigt. Ein Vergleich zwischen S_{E,i} und S_{E} zeigt, dass der Aktor falsch angeschlossen sein muss, unabhängig davon, welches Signal der Bewegungssensor ausgibt.

Fig. 6E zeigt den Fall der doppelten Invertierung. Hier ist entspricht das Bewegungssignal P_{2,i} dem Prüfsignal P_{2,o}. Jedoch ist das energieindikative Signal S_{E,i} wie in Fig. 6D ausgeprägt. Die Bewegungsrichtung entgegen der Schwerkraft würde gemäß dem energieindikative Signal S_{E,i} weniger Energie benötigen als das Referenzsignal S_{E}, worin ein Widerspruch liegt. Dies kann von der Steuereinrichtung detektiert werden und zeigt, dass der Aktor falsch angeschlossen ist.

Mit den in Figs. 6A-6E gezeigten Fällen ist somit nicht bloß die Detektion einer auftretenden Invertierung möglich. Vielmehr kann auch zwischen aktorseitigen und sensorseitigen Invertierungen unterschieden werden. Somit kann die Stelle der auftretenden Invertierung festgestellt werden.

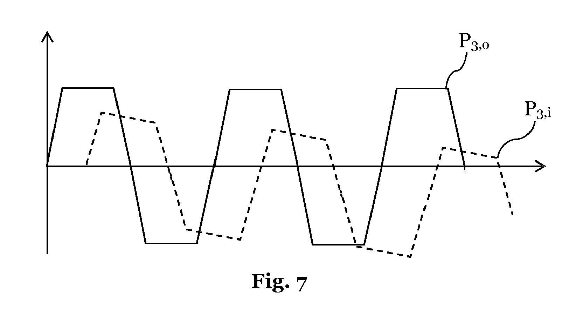

Fig. 7 zeigt ein periodisches Prüfsignal P_{3,o} und ein Bewegungssignal P_{3,i}, welches Bewegungssignal P_{3,i} eine Phasenverschiebung, eine Änderung der Amplitude als auch eine Änderung der Flankensteigung aufweist. Die Auswertung der Flankensteigung kann dazu genutzt werden, die Bewegungsrichtungen des Aktors 100 unabhängig von einem energieindikative Signal, trotz auftretender Invertierungen zu erfassen.

Gemäß dieser Ausführungsform ist zumindest eine Achse A1-A6 des Industrieroboters 1 eine schwerkraftbelastete Achse oder zum Zwecke der Überprüfung der richtigen Zuordnung mit einer Kraft beaufschlagt. Die Steuereinrichtung 100 vergleicht die Steigung der entsprechenden Flanken des Prüfsignals P_{3,o} und des Bewegungssignals P_{3,i}.

Das Prüfsignal P_{3,o} ist in Fig.7 als durchgezogene Linie, das Bewegungssignal P_{3,i} als gestrichelte Linie dargestellt. Das Prüfsignal P_{3,o} kann beispielsweise ein Aktormoment vorgeben. Das Bewegungssignal P_{3,i} gibt vorzugsweise eine Geschwindigkeit wieder. Eine Änderung der Flankensteigung im Bewegungssignal deutet auf eine, neben dem Aktormoment wirkende Kraft hin, da das bewegte Glied in Richtung der Kraft beschleunigt oder durch die Kraft abgebremst wird. Das Aktormoment ist das Moment, welches durch den Aktor erzeugt wird. Die zusätzlich wirkende Kraft ist beispielsweise die Schwerkraft oder eine auf den Antrieb aufgebrachte Kraft. Die Steuereinrichtung 100 vergleicht die Steigung der entsprechenden Flanken des Prüfsignals P_{3,o} und des Bewegungssignals P_{3,i}. Wird eine Abweichung der Flankensteigung detektiert, so kann rückgeschlossen werden, dass der Antrieb mit einer zusätzlichen Kraft beaufschlagt ist. Im Falle einer steileren Flanke des Bewegungssignals P_{3,i} wird der Antrieb im Wesentlichen mit der zusätzlichen Kraft bewegt und im Falle einer flacheren Flanke im Wesentlichen gegen die zusätzlich wirkende Kraft. Analog zu den Erläuterungen zu Fig. 6A-E ist es somit möglich den Ort der Invertierung innerhalb der Zuordnung eines Antriebs, als auch doppelte Invertierungen zu erfassen (vgl. Antrieb x=3, Fig. 3).

In einer vorteilhaften Weiterbildung übergibt die Steuereinrichtung 100 die ermittelte Zuordnung der Antriebe x=1- 4 und der Bewegungssensoren 401 - 404 an das Steuerprogramm P. Im Steuerprogramm P wird die hinterlegte Zuordnung entsprechend geändert, sodass die korrekte Zuordnung nicht durch Änderung der Konnektierung der Antriebe oder Bewegungssensoren an der Steuereinrichtung erfolgt. Dadurch kann eine Vertauschung und eine Invertierung der Signalleitungen ausgeglichen werden. Die Maschine bzw. der Roboter ist nicht auf eine bestimmte Zahl an Antrieben und Bewegungssensoren limitiert, sondern richtet sich vielmehr an eine beliebige Zahl von Antrieben, deren Zuordnung zu einer Steuereinrichtung durch das Verfahren bestimmt werden kann.

### 5. Bezugszeichenliste

- 1:: Industrieroboter
- 2:: Glied
- 3:: Signalleitung
- 4:: Steigende Flanke
- 5:: Fallende Flanke
- 10:: Antrieb
- 100:: Steuereinrichtung
- 200:: Ansteuereinrichtung
- 201 - 204:: Ansteuereinrichtungen
- 300:: Aktor
- 301 - 304:: Aktoren
- 400:: Bewegungssensor
- 401 - 404:: Bewegungssensoren
- A1-A6:: Achsen
- i₁ - i₄:: Signaleingänge der Steuereinrichtung
- o₁ - o₄:: Signalausgänge der Steuereinrichtung
- P₀:: Steuersignal
- P_{1,0} ;P_{2,0;}:: Periodisches Prüfsignal
- P_{3,0}:: Periodisches, sägezahnartiges Prüfsignal
- Pᵢ:: Bewegungssignal
- P_{1,i} - P_{3,i}:: Bewegungssignale
- S_{E}:: Signal - Energieverbrauch des Aktors
- S_{E,i}:: Signal - Energieverbrauch des Aktors, wenn schwerkraftbelastet
- k:: Änderung der Amplitude
- T:: Periodendauer
- ϕ: Phasenverschiebung

## Patentansprüche

1. Verfahren zur Überprüfung der Zuordnung von Antrieben (10) einer Maschine (1), welche mehrere Achsen (A1-A6) aufweist, wobei den Achsen jeweils ein Antrieb (10) zugeordnet ist und wobei jeder Antrieb (10) zumindest einen Aktor (300) und einen Bewegungssensor (400) umfasst, der der vom Antrieb (10) zu bewegenden Achse zugeordnet ist, zu einer Steuereinrichtung (100), welche dazu eingerichtet ist die Maschine (1) mittels eines Steuerprogramms (P) zu steuern, wobei das Verfahren die folgenden Verfahrensschritte umfasst:
a) die Steuereinrichtung (100) ein Prüfsignal (P_{1,o}; P_{2,o}; P_{3,o}) an zumindest einen Antrieb (10) ausgibt;
b) der Aktor (300) dieses Antriebs in Reaktion auf das Prüfsignal (P_{1,o}) entsprechende Bewegungen der Achsen (A1-A6) der Maschine (1) veranlasst;
c) der zugeordnete Bewegungssensor (400) die Bewegung erfasst und entsprechende Bewegungssignale (P_{1,i}; P_{2,i}; P_{3,i}) an die Steuereinrichtung sendet, und
d) die Steuereinrichtung das Prüfsignal (P_{1,o}; P_{2,o}; P_{3,o}) mit den Bewegungssignalen (P_{1,i}; P_{2,i}; P_{3,i}) vergleicht, um eine Phasenverschiebung (ϕ), eine Invertierung und/oder eine Änderung der Amplitude (k) zu detektieren.

2. Das Verfahren nach Anspruch 1, wobei das Prüfsignal (P_{2,o}) für die beiden Bewegungsrichtungen des Aktors unterschiedliche Beschleunigungen, Geschwindigkeiten und/oder zu fahrende Wege vorgibt.

3. Das Verfahren nach einem der vorhergehenden Ansprüche, wobei die Steuereinrichtung (100) die Schritte a) bis d) für alle Antriebe wiederholt.

4. Das Verfahren nach einem der vorhergehenden Ansprüche, wobei das Prüfsignal (P_{1,o}; P_{2,o}; P_{3,o}) einen Verlauf hat, der die Detektion einer Invertierung unabhängig von der Phasenverschiebung (ϕ) ermöglicht.

5. Das Verfahren nach einem der vorhergehenden Ansprüche, wobei das Prüfsignal (P_{1,o}; P_{2,o}; P_{3,o}) ein periodisches Signal ist.

6. Das Verfahren nach einem der vorhergehenden Ansprüche, **dadurch gekennzeichnet, dass** bei Detektion einer Phasenverschiebung (ϕ), einer Invertierung und/oder einer Änderung der Amplitude (k) die Steuereinrichtung (100) eine Meldung erzeugt, dass die Zuordnung des überprüften Antriebs falsch ist.

7. Das Verfahren nach einem der vorhergehenden Ansprüche, wobei der Steuereinrichtung (100) weiter für den Energieverbrauch des Aktors (300) indikative Signale (S_{E,i}) bereitgestellt werden, und die Steuereinrichtung (100) diese Signale (S_{E,i}) mit den Bewegungssignalen (P_{1,i}; P_{2,i}; P_{3,i}) und dem Prüfsignal (P_{1,o}; P_{2,o}; P_{3,o}) vergleicht, um bei schwerkraftbelasteten Achsen die Bewegungsrichtungen des Aktors (100) unabhängig von den Bewegungssignalen (P_{1,i}; P_{2,i}; P_{3,i}) zu erfassen.

8. Das Verfahren nach einem der vorhergehenden Ansprüche, wobei das Prüfsignal (P_{1,o}; P_{2,o}; P_{3,o}) eine Bewegungsamplitude des Glieds auslöst, welche kleiner 1 cm, bevorzugt kleiner 0.5 cm und besonders bevorzugt kleiner 1 mm ist bzw. eine Drehbewegung des Gliedes auslöst, welche kleiner 1 Grad, bevorzugt kleiner 0.5 Grad und besonders bevorzugt kleiner 0.1 Grad ist.

9. Das Verfahren nach einem der vorhergehenden Ansprüche, wobei die Steuereinrichtung (100) das Prüfsignal (P_{1,o}; P_{2,o}; P_{3,o}) mit den Bewegungssignalen (P_{1,i}; P_{2,i}; P_{3,i}) vergleicht, um die Phasenverschiebung (ϕ) und/oder die Änderung der Amplitude (k) zu detektieren und wobei die Phasenverschiebung (ϕ) und/oder die Änderung der Amplitude (k) für jeden Antrieb charakteristisch ist und entsprechende Soll-Werte der Steuereinrichtung zur Verfügung stehen, wobei die Steuereinrichtung (100) die gemessenen Ist-Werte mit den entsprechenden Soll-Werten des Antriebs vergleicht.

10. Das Verfahren nach einem der vorhergehenden Ansprüche, wobei die Steuereinrichtung (100) die ermittelte Zuordnung der Antriebe (10) und der Bewegungssensoren (400) an das Steuerprogramm (P) übergibt, und dieses die Zuordnung entsprechend ändert, sodass die korrekte Zuordnung nicht durch Änderung der Konnektierung der Antriebe (10) oder Bewegungssensoren (400) an der Steuereinrichtung (100) erfolgt.

11. Das Verfahren nach einem der vorigen Ansprüche, wobei die Maschine ein Roboter, insbesondere ein Gelenkarmroboter, ist.

12. Anordnung einer Maschine (1) mit zumindest zwei antreibbaren Achsen (A1-A6) und einer Steuereinrichtung (100), wobei die Steuereinrichtung ausgelegt ist, ein Verfahren gemäß eines der vorigen Ansprüche auszuführen.

13. Computerlesbares Medium, auf welchem Instruktionen gespeichert sind, die, wenn sie auf einer geeigneten Steuereinrichtung (100) geladen sind und ausgeführt werden, ein Verfahren gemäß eines der Ansprüche 1 bis 12 durchführen.
